# EUROPEAN PATENT SPECIFICATION

(11) **EP 3 522 227 B1**
(45) Date of publication and mention of the grant of the patent: **28.12.2022**
(21) Application number: 19155806.3
(22) Date of filing: 06.02.2019
(51) Int. Cl.: H01L 27/30, H01L 51/42

(54) **ORGANIC IMAGE SENSORS WITHOUT COLOR FILTERS**
ORGANISCHE BILDSENSOREN OHNE FARBFILTER
CAPTEURS D'IMAGES ORGANIQUES SANS FILTRES DE COULEUR

(30) Priority: 06.02.2018 KR 20180014579
(43) Date of publication of application: 07.08.2019
(73) Proprietor: Samsung Electronics Co., Ltd., Suwon-si, Gyeonggi-do, 16677 (KR)
(72) Inventor: LEE, Gae Hwang, Gyeonggi-do (KR); LEE, Kwang Hee, Gyeonggi-do (KR); YUN, Sung Young, Gyeonggi-do (KR); LEEM, Dong-Seok, Gyeonggi-do (KR); JIN, Yong Wan, 01387 Seoul (KR)
(74) Representative: Elkington and Fife LLP

(56) References cited:
- EP-A1- 2 568 517
- EP-A1- 3 113 225
- WO-A1-2009/056626
- WO-A1-2017/159025
- SCHULTES S M ET AL: "The role of molecular architecture and layer composition on the properties and performance of CuPc-C60 photovoltaic devices", MATERIALS SCIENCE AND ENGINEERING C, ELSEVIER SCIENCE S.A, CH, vol. 25, no. 5-8, 10 August 2005 (2005-08-10), pages 858-865, XP027803949, ISSN: 0928-4931 [retrieved on 2005-12-01]

## Description

### FIELD OF THE INVENTION

Example embodiments relate to image sensors. More particularly, example embodiments relate to organic image sensors without color filters.

### BACKGROUND OF THE INVENTION

In some cases, an organic/inorganic stacked image sensor may be formed by stacking a green organic photodiode and a silicon photodiode, where the silicon photodiode includes a red silicon photodiode and a blue silicon photodiode.

In some cases, a color filter is included in the organic/inorganic stacked image sensor to configure the image sensor to obtain ("generate") a desirable red, green, and blue (RGB, or CMY) color signal based on incident light on the image sensor. In some cases, when the color filter is present between the organic photodiode and the silicon photodiode of the image sensor, a process of operating the image sensor and/or manufacturing the image sensor may become difficult and complicated due to a thickness (about 500-1000 nm) of the color filter. In addition, a distance between the organic photodiode and the silicon photodiode may be almost several hundreds of nanometers, so optical crosstalk between the organic photodiode and the photodiodes of the silicon photodiode may be increased. Also, it may be difficult to provide an electrode in a depth direction.

When the color filter is present on the organic photodiode in the image sensor, the color filter may filter a CMY (Cyan, Magenta, Yellow) color, but CMY color filters may be difficult to provide a fine pattern and has a low color purity, so that it may be difficult to apply a CMY filter in an image sensor product.

Furthermore, a color filter that may be included in an image sensor may include an organic material such as a colorant (pigment or dye) and may be formed according a process such as a spin coating, a UV exposure, a dry etching, so there is a limit to reduce a pattern size or a thickness until less than or equal to about 1 um. Accordingly, a color filter included in an image sensor may degrade performance and/or resolution of the image sensor. EP 3113225A discloses an organic image sensor including an organic photoelectric conversion layer including a first material and a second material, where the first material is configured to absorb a first wavelength spectrum of light, and the second material is configured to absorb a second wavelength spectrum of light. The organic photoelectric conversion layer includes a lower layer and an upper layer stacked upon the lower layer. The material compositions of the lower and upper layers are first and second mixtures respectively of the first and second materials. The ratio of the first material to the second material in the first mixture is 3:1, greater than 1:1, and the ratio of the first material to the second material in the second mixture is 1:3, less than 1:1.

Organic photodetectors with different materials for absorbing different respective wavelengths and with layered structures are known from each of WO 2009/056626A, EP 2568517A and SCHULTES S M ET AL: "The role of molecular architecture and layer composition on the properties and performance of CuPc-C60 photovoltaic devices", MATERIALS SCIENCE AND ENGINEERING C, ELSEVIER SCIENCE S.A., CH, vol.25, no. 5-8, 1 December 2005 (2005-12-01), pages 858-865, XP027803949). Organic/inorganic image sensors without a color filter are known from WO 2017/159025 A1.

### SUMMARY OF THE INVENTION

The invention is defined by the claims.

According to an aspect of the invention, there is provided an organic image sensor according to claim 1.

According to another aspect of the invention, there is provided an organic/inorganic stacked image sensor according to claim 5.

### BRIEF DESCRIPTION OF THE DRAWINGS

FIG. 1 is a schematic view showing a pixel arrangement of an image sensor according to some example embodiments.
FIG. 2 is a cross-sectional view cut along with a II-II' line of FIG. 1 according to some example embodiments.
FIG. 3 is a schematic view showing a read out circuit of an image sensor according to some example embodiments.
FIG. 4 is a schematic view illustrating an operation principle of an image sensor according to the present invention.
FIGS. 5A, 5B, and 5C are schematic views each showing a possible combination of color and a possible way of extracting signals according to some example embodiments.
FIG. 6 is a view showing that a color ratio of a pixel may be adjusted according to an applied voltage according to present invention.
FIGS. 7A and 7B are graphs showing the results measured by an external quantum efficiency (EQE) of an organic photoelectric conversion layer formed by blending BIDD Se:C₆₀ according to an applied voltage and the results of simulating an external quantum efficiency for each wavelength using the same according to some example embodiments.
FIGS. 8A and 8B are graphs showing the results measured by an external quantum efficiency (EQE) of an organic photoelectric conversion layer formed by blending SubPc-C₆₀ according to an applied voltage and the results of simulating an external quantum efficiency for each wavelength using the same according to some example embodiments.
FIG. 9 is a cross-sectional view cut along with a II-II' line of FIG. 1 according to some example embodiments.

### DETAILED DESCRIPTION

Hereinafter, some example embodiments will be described more fully with reference to the accompanying drawings. The described example embodiments may be modified in various different ways and not limited to the specific examples described herein, all without departing from the scope of the present inventive concepts.

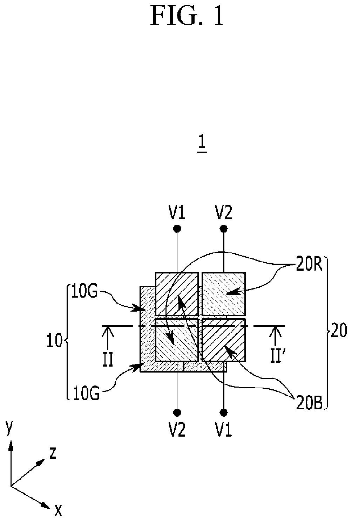

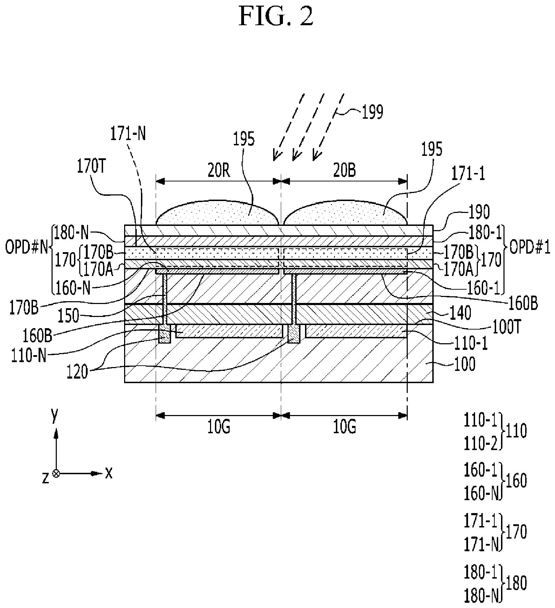

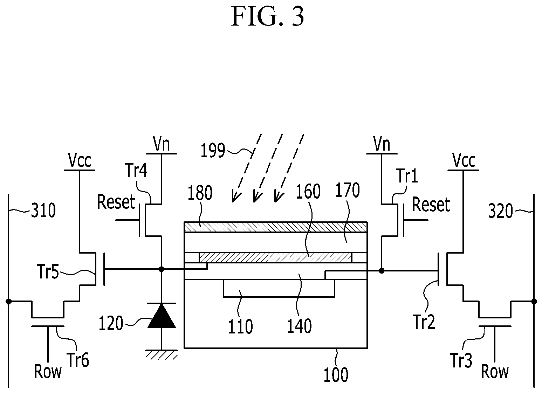

FIG. 1 is a schematic view showing a pixel alignment of an image sensor according to some example embodiments. FIG. 2 is a cross-sectional view cut along with a II-II' line of FIG. 1 according to some example embodiments. FIG. 3 is a schematic view showing a read out circuit of an image sensor according to some example embodiments.

Referring to FIG. 1, an image sensor 1 according to some example embodiments includes an inorganic pixel array 10 in which a first pixel 10G for detecting a first light (green light) is entirely arranged in a x-y direction and an organic pixel array 20 in which a second pixel 20B for detecting second light (blue light) and a third pixel (20R) for detecting third light (red light) are alternatively arranged in a x-y direction. The inorganic pixel array 10 and the organic pixel array 20 are stacked in a z-direction.

In a normal operation mode, a second pixel 20B and a third pixel 20R may be alternatively disposed in the same number, such that a ratio of second pixels 20B to third pixels 20R in the image sensor 1 may be 1/1. In some example embodiments, the second pixel 20B may be applied with a first voltage V1 to configured the second pixel 20B to detect second light (blue light), and the third pixel 20R may be applied with a second voltage V2 which is different from the first voltage V1 to configured the third pixel 20R to detect third light (red light). In some example embodiments, the second voltage V2 may be applied in the third pixel 20R concurrently (e.g., simultaneously) with the first voltage being applied in the second pixel 20B.

The specific operations thereof are described with references to FIG. 2 showing a cross-sectional view cut along with Line II-II' of FIG. 1 and FIG. 3 illustrating the operation principle.

Referring to FIG. 2, the image sensor 1 includes an inorganic photoelectric conversion device 110 formed on a semiconductor substrate 100 and providing ("defining") a first pixel 10G. In some example embodiments, including the example embodiments shown in FIG. 2, the inorganic photoelectric conversion device 110 may be at least partially embedded within the semiconductor substrate 100, such that the inorganic photoelectric conversion device 110 is at least partially located within a volume defined by the outer surfaces (e.g., upper surface 100T) of the semiconductor substrate 100. As further shown in FIG. 2, the inorganic photoelectric conversion device 110 may include a plurality (e.g., an array) of inorganic photoelectric conversion devices 110-1 to 110-N (where N may be a positive integer) in the semiconductor substrate 100.

The semiconductor substrate 100 is not limited to a substrate of which the whole is a semiconductor layer but may be an insulator substrate including a semiconductor layer on a surface where light is irradiated.

When the semiconductor substrate 100 is a n-type, the inorganic photoelectric conversion device 110 may include a p well layer formed thereon, a n layer formed in the p well layer, and a p layer for suppressing a dark current having a higher concentration of impurities than the n layer. The most of inorganic photoelectric conversion device 110 is formed with the n layer to accumulate a charge.

A charge accumulated in the inorganic photoelectric conversion device 110 is sensed using a readout circuit including a transistor having a 3-transistor structure or a 4-transistor structure, and the like.

An interlayer insulating layer 140 is provided on the semiconductor substrate 100 formed with the inorganic photoelectric conversion device 110, and an organic photoelectric conversion layer 170 is provided thereon.

As shown in FIG. 2, the organic photoelectric conversion layer 170 may be divided into multiple organic photoelectric conversion devices OPD#1 to OPD#N (where "N" is a positive integer) which may include, as shown in FIG. 2, a first organic photoelectric conversion device (OPD#1) for a second pixel 20B and a second organic photoelectric conversion device (OPD#N) for a third pixel 20R according to a combination of a common electrode 180 thereon and separate pixel electrode 160-1 to 160-N, of a plurality of pixel electrodes 160, formed in each pixel under the same. As shown in FIG. 2, the division between of the image sensor 1 into separate organic photoelectric conversion devices OPD#1 to OPD#N may be based upon the separate pixel electrodes 160-1 to 160-N defining the separate organic photoelectric conversion devices OPD#1 to OPD#N, such that each organic photoelectric conversion device includes a separate pixel electrode 160-1 to 160-N and a separate portion of each of the common electrode 180 and the organic photoelectric conversion layer 170. Restated, and as shown in FIG. 2, the plurality of pixel electrodes 160-1 to 160-N may define separate organic photoelectric conversion devices OPD#1 to OPD#N in the organic image sensor 1, such that, for example, where N is equal to or greater than 2, the first organic photoelectric conversion device OPD#1 includes a first pixel electrode 160-1 of the plurality of pixel electrodes 160, a first portion 171-1 of the organic photoelectric conversion layer 170 and a first portion 180-1 of the common electrode 180, and a separate, second organic photoelectric conversion device OPD#N may include a separate, second pixel electrode 160-N of the plurality of pixel electrodes 160, a separate, second portion 171-N of the organic photoelectric conversion layer 170 and a separate, second portion 180-2 of the common electrode 180. As further shown in FIG. 2, the common electrode 180 is on one side (e.g., upper surface 170T) of the organic photoelectric conversion layer 170, and the plurality of pixel electrodes 160 are on an opposite side (e.g., lower surface 170S) of the organic photoelectric conversion layer 170.

As described herein, an element that is "on" another element may be above or beneath the other element. Additionally, an element that is "on" another element may be "directly" on the other element such that the element directly contacts the other element, or the element may be "indirectly" on the other element such that the element is isolated from direct contact with the other element by one or more interposing spaces and/or structures.

In the present invention, the image sensor 1 is configured to independently apply the first voltage V1 to one organic photoelectric conversion device (e.g., the first organic photoelectric conversion device OPD#1) and apply the second voltage V2 to a separate organic photoelectric conversion device (e.g., a second organic photoelectric conversion device OPD#N where N is equal to or greater than 2), where the first voltage V1 and the second voltage V2 are applied concurrently (e.g., simultaneously) and independently of each other.

A planarization layer 190 that is transparent to incident light is formed on the common electrode 180. A microlens 195 is formed on the planarization layer 190 to focus the incident light onto each pixel in a site corresponding to each pixel.

Each pixel electrode 160-1 to 160-N is connected with a separate charge storage section 120 through a separate contact 150 filled in a via formed in an interlayer insulation layer 140. Restated, the image sensor 1 may include an interlayer insulation layer 140 between an upper surface 100T of the semiconductor substrate 100 and an exposed lower surface 170S of the organic photoelectric conversion layer 170, and separate, respective contacts 150 configured to couple (e.g., electrically couple) the separate, respective organic photoelectric conversion devices OPD#1 to OPD#N with separate, respective sections 120 in the semiconductor substrate 100. As shown in FIG. 2, the interlayer insulating layer may be directly on a lower surface 160B of the plurality of pixel electrodes 160 and an exposed lower surface 170S of the organic photoelectric conversion layer 170. It will be understood that the semiconductor substrate 100 may be referred to as being "on" the interlayer insulating layer 140, as an element that is "on" another element may be above or beneath the other element.

A charge accumulated in the inorganic photoelectric conversion device 110 and a charge accumulated in the charge storage section 120 are sensed using a readout circuit including a transistor having a 3-transistor structure or a 4-transistor structure, and the like.

Referring to FIG. 3, a charge accumulated in the inorganic photoelectric conversion device 110 is readout by a reset transistor Tr1 having a drain connected to the inorganic photoelectric conversion device 110 and a source connected to a power source Vn, an output transistor Tr2 having a gate connected to the drain of the reset transistor Tr1 and a source connected to the power source Vcc, and a row selective transistor Tr3 having a source connected to the drain of the output transistor Tr2 and a drain connected to the signal output line 320.

The charge accumulated in the charge storage section 120 is readout by a reset transistor Tr4 having a drain connected to the charge storage section 120 and a source connected to a power source Vn, an output transistor Tr5 having a gate connected to the drain of the reset transistor Tr4 and a source connected to the power source Vcc, and a row selective transistor Tr6 having a source connected to the drain of the output transistor Tr5 and a drain connected to the signal output line 310.

A charge generated and stored in the inorganic photoelectric conversion device 110 is converted to a signal corresponded to an amount of charge through the output transistor Tr2. When the row selective transistor Tr3 is turned on, the signal is output to the signal output line 320. After outputting the signal, the charge of the inorganic photoelectric conversion device 110 is reset by the reset transistor Tr1. If required, it may further include a delivery transistor (not shown) between the inorganic photoelectric conversion device 110 and the drain of the reset transistor Tr1.

When a bias voltage is applied between a pixel electrode 160-1 to 160-N and the common electrode 180 (e.g., the first voltage V1 and/or the second voltage V2), which may be referred to as applying a particular voltage to a particular organic photoelectric conversion device OPD#1 to OPD#N that includes the given pixel electrode 160-1 to 160-N, a charge is generated corresponding to light 199 (also referred to herein as "incident light") having entered the organic photoelectric conversion layer 170 and is transported to a given charge storage section 120 through a given contact 150 connected with the given pixel electrode 160-1 to 160-N. The charge stored in the charge storage section 120 is converted to a signal corresponding to an amount of charge through the output transistor Tr5. Such a signal may also be interpreted as being associated with one or more particular wavelength spectra of incident light 199 that is absorbed by the given organic photoelectric device. When the row selective transistor Tr6 is turned on, the signal is output to the signal output line 310. After outputting the signal, the charge of the charge storage section 120 is reset by the reset transistor Tr4. If required, it may further include a delivery transistor (not shown) between the charge storage section 120 and the drain of the reset transistor Tr4.

In the image sensor 1, the organic photoelectric conversion layer 170 detects different lights from each other (e.g., detects different wavelength spectra of incident light 199) depending upon different applied voltages (e.g., depending upon different magnitudes of voltage(s) applied to different organic photoelectric conversion device(s) that include different portions 171-1 to 171-N of the organic photoelectric conversion layer 170). As shown in FIG. 2, the organic photoelectric conversion layer 170 is formed by stacking layers (170A, 170B) having different ratios of blending a first material (also referred to herein as "material A") and a second material (also referred to herein as "material B") which have different light absorbance characteristics from each other, so as to be configured to detect different wavelength spectra of light according to the applied voltage. Restated, the first material is configured to absorb a first wavelength spectrum of light, and the second material is configured to absorb a second wavelength spectrum of light, and the first and second wavelength spectra may be different from each other. The first wavelength spectrum of light may be referred to herein as "first light" and the second wavelength spectrum of light may be referred to herein as "second light."

For example, the image sensor 1 may include a lower layer 170A including a higher ratio of the material B configured to absorb red light and having an excellent charge transport property and a upper layer 170B including a higher ratio of the material A configured to absorb blue light and having a low electric characteristic. Restated, the material composition of the lower layer 170A includes a first mixture of the first material and the second material, and the material composition of the upper layer 170B includes a second mixture of the first material and the second material, where the ratio of the first material to the second material in the first mixture is greater than 1/1 (e.g., 2/1), and the ratio of the first material to the second material in the second mixture is less than 1/1 (e.g., 1/2).

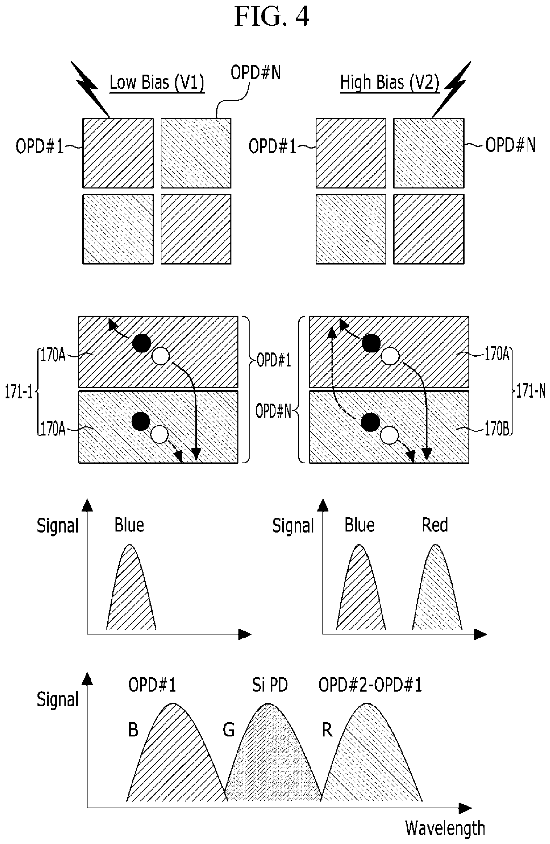

FIG. 4 is a schematic view illustrating an operation principle of an image sensor according to the present invention.

In some example embodiments, the second voltage V2 that is applied in a second organic photoelectric conversion device OPD#N of the image sensor 1 (where N is equal to or greater than 2) has a magnitude that is greater than a magnitude of the first voltage V1 that is applied in a first organic photoelectric conversion device OPD#1 of the image sensor 1, such that the first voltage V1 may be referred to as a "low bias voltage" and the second voltage V2 may be referred to as a "high bias voltage."

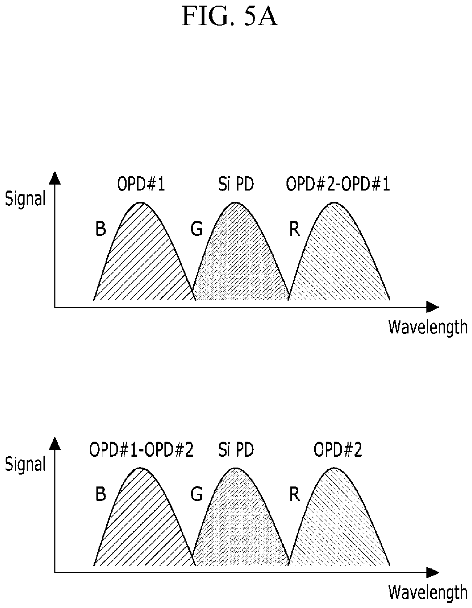

In an example shown in FIG. 4, when a low voltage bias (V1) is applied to a first organic photoelectric conversion device OPD#1, a charge may be separated in both the lower layer 170A and the upper layer 170B of the first organic photoelectric conversion device OPD#1, but charges absorbing blue light (a portion of incident light 199 that is in the blue wavelength spectrum) are collected while being transported through the lower layer 170A having an excellent charge transport characteristic, on the other hand, charges absorbing red light (a portion of incident light 199 that is in the red wavelength spectrum) may be not transported through the upper layer 170B having a low charge transporting characteristic. Thereby, blue light may be detected by the first organic photoelectric conversion device OPD#1 based on the low voltage bias V1 being applied to the first organic photoelectric conversion device OPD#1, and a signal corresponding to said detection may be generated by the first photoelectric conversion device OPD#1. As further shown in FIG. 4, when a high voltage bias V2 is applied to the second organic photoelectric conversion device OPD#N, charges absorbing red light may be transported through the upper layer 170B having a charge transport characteristic, so both blue and red light (e.g., light in both the red and blue wavelength spectra) may be detected by the second organic photoelectric conversion device OPD#N, and the second organic photoelectric conversion device OPD#N may thus generate a signal that is based on the detection of both blue light and red light by the second organic photoelectric conversion device OPD#N. Accordingly, in some example embodiments, and as shown in FIG. 4, a blue signal (a signal indicating detection of blue light by the image sensor 1) may be obtained from the signal generated by the first organic photoelectric conversion device (OPD#1), and a red signal (a signal indicating detection of red light by the image sensor 1) may be obtained based on subtracting the signal generated by the first organic photoelectric conversion device (OPD#1) from the signal generated by the second organic photoelectric conversion device (OPD#N). Restated, and as described further with regard to FIGS. 5A-5C, a signal associated with one light of a first light and a second light may be obtained based on processing a signal generated by a first organic photoelectric conversion device OPD#1 applied with a first voltage V1, and a signal associated with the other light of the first light and the second light may be obtained based on processing a separate signal generated by a second organic photoelectric conversion device OPD#N applied with a separate, second voltage V2.

Restated, the image sensor 1 may be configured to 1) configure the first organic photoelectric conversion device OPD#1 to generate a signal associated with one light of the first light and the second light based on the image sensor applying a first voltage V1 to the first organic photoelectric conversion device OPD#1 and the image sensor 1 being irradiated with incident light 199 that includes the first light and the second light, and 2) configure the second organic photoelectric conversion device OPD#N to generate a signal associated with a separate light of the first light and the second light based on the image sensor applying a separate, second voltage V2 to the second organic photoelectric conversion device OPD#N and the image sensor 1 being irradiated with the incident light 199. The image sensor 1 may be configured to configure the first and second organic photoelectric conversion devices OPD#1 and OPD#N independently from each other, based on independently applying separate voltages to separate organic photoelectric conversion devices of the image sensor 1.

In order to increase the signal selectivity, the B material is blended with the A material in greater than or equal to about 3 times of the A material for the lower layer 170A, but for the upper layer 170B, the A material is blended with the B material in greater than or equal to about 3 times of the B material. Restated, a ratio of the first material to the second material in the first mixture that is the material composition of the lower layer 170A may be greater than 3/1, and a ratio of the first material to the second material in the second mixture that is the material composition of the upper layer 170B may be less than 1/3.

When the organic photoelectric conversion layer 170 is configured to absorb red light and blue light, (ZnPc, C₆₀) or (CuPc, C₆₀) may be used as a combination ("mixture") of the material A and the material B.

In the organic/inorganic stacked image sensor of the present invention, each inorganic photoelectric conversion device 110-1 to 110-N of the inorganic photoelectric conversion device 110 is configured to absorb ("detect") a third light that is not absorbed by the first and second organic photoelectric conversion devices OPD#1 and OPD#N. When the organic photoelectric conversion layer 170 is configured to absorb red light and green light (light in the green wavelength spectrum), (BIDD Se, CuPc) or (SubPc, CuPc) may be used as a combination of the material A and the material B. In some example embodiments, the inorganic photoelectric conversion element 110 may be configured to absorb the blue light.

When the organic photoelectric conversion layer 170 is configured to absorb blue light and green light, (BIDD Se, C₆₀), (SubPc, C₆₀), or (DCV3T, C60) may be used as a combination of the material A and the material B. In some example embodiments, the inorganic photoelectric conversion element 110 may be configured to absorb the red light.

The image sensor 1 may have a selectivity to different two colors of RGB (two different wavelength spectra of red, green, and blue wavelength spectra) based on changing a voltage applied to at least a portion of the organic photoelectric conversion layer 170 (e.g., changing a voltage applied to an organic photoelectric conversion device that includes at least a portion 171-1 to 171-N of the organic photoelectric conversion layer 170. As the organic photoelectric conversion layer 170 already absorbs (also referred to herein as "detects") two different colors of RGB (e.g., two different wavelength spectra, of blue, red, and green wavelength spectra, of incident light 199), the remaining one color (wavelength spectrum) may be selectively delivered ("transmitted") to the inorganic photoelectric conversion device 110. Thereby, the image sensor 1 may omit ("may not include") any separate color filter ("color filter device"). In some example embodiments, in order to increase the selectivity to the remaining one color for the inorganic photoelectric conversion device 110, the depth of the inorganic photoelectric conversion device 110 in the semiconductor substrate 100 from the upper surface 100T of the semiconductor substrate 100 may be adjusted corresponding to a wavelength of the color ("wavelength spectrum" of incident light 199) to be detected. As referred to herein, it will be understood that a "color" may refer to a particular wavelength spectrum of incident light 199.

When a color filter is not included between the organic photoelectric conversion layer 170 and the inorganic photoelectric conversion device 110 of the image sensor 1, the distance between the organic photoelectric conversion layer 170 and the inorganic photoelectric conversion device 110 may be reduced to less than or equal to about 100 nm. The distance (for example, 500nm) is shorter in less than or equal to at least about 1/5 times of a distance of a case that a color filter is existed between the organic photoelectric conversion layer 170 and the inorganic photoelectric conversion device 110. When the distance between the organic photoelectric conversion layer 170 and the inorganic photoelectric conversion device 110 is reduced to less than or equal to about 100 nm, the optical crosstalk may be reduced. In addition, as a depth of a via for the contact 150 formed in the interlayer insulation layer 140 is reduced, it is much facilitated to carry out a via forming process.

When the terms "around," "about," or "substantially" are used in this specification in connection with a numerical value, it is intended that the associated numerical value include a tolerance of ±10% around the stated numerical value. When ranges are specified, the range includes all values therebetween such as increments of 0.1%.

In addition, when the color filter itself is not included in the image sensor 1, the difficulties to provide a fine pattern of the color filter or to provide a thin film may be fundamentally solved.

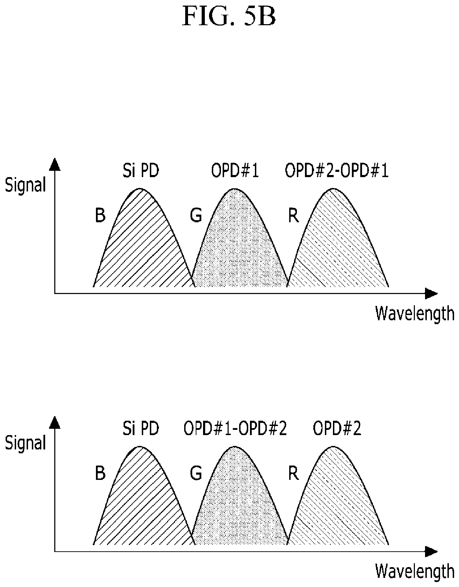

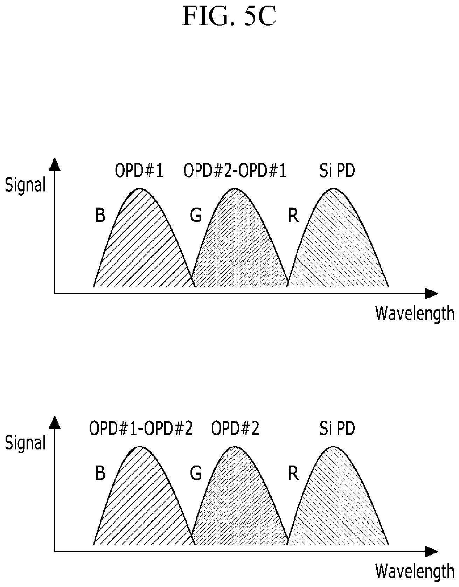

FIGS. 5A, 5B, and 5C are schematic views each showing a possible combination of colors (wavelength spectra of incident light 199) that various organic photoelectric conversion devices of the image sensor may be configured to detect and a possible way of extracting signals according to some example embodiments.

FIG. 5A shows some example embodiments of signals generated by an image sensor that includes an organic photoelectric conversion layer 170 configured to absorb red and blue light. As shown in the upper chart of FIG. 5A, when the image sensor detects blue light in the first organic photoelectric conversion device (OPD#1) and detects both blue light and red light in a second organic photoelectric conversion device (OPD#N), the signal generated by the first organic photoelectric conversion device (OPD#1) may be subtracted from the signal generated by the second organic photoelectric conversion device (OPD#N) to obtain a red signal, while the signal generated by the first organic photoelectric conversion device (OPD#1) may be the blue signal. As shown in the lower chart of FIG. 5A, when the image sensor detects red light in the second organic photoelectric conversion device (OPD#N) and detects blue light and red light in the first organic photoelectric conversion device (OPD#1), the signal generated by the second organic photoelectric conversion device (OPD#N) may be subtracted from the signal generated by the first organic photoelectric conversion device (OPD#1) to obtain a blue signal, while the signal generated by the second organic photoelectric conversion device (OPD#N) may be the red signal.

FIG. 5B shows some example embodiments of signals generated by an image sensor that includes an organic photoelectric conversion layer 170 configured to absorb green and red light. As shown in the upper chart of FIG. 5B, when the image sensor detects green light in the first organic photoelectric conversion device (OPD#1) and detects both green light and red light in the second organic photoelectric conversion device (OPD#N), the signal generated by the first organic photoelectric conversion device (OPD#1) may be subtracted from the signal generated by the second organic photoelectric conversion device (OPD#N) to obtain a red signal, while the signal generated by the first organic photoelectric conversion device (OPD#1) may be the green signal. As shown in the lower chart of FIG. 5B, when the image sensor detects red light in the second organic photoelectric conversion device (OPD#N) and detects both green light and red light in the first organic photoelectric conversion device (OPD#1), the signal generated by the second organic photoelectric conversion device (OPD#N) may be subtracted from the signal generated by the first organic photoelectric conversion device (OPD#1) to obtain a green signal, while the signal generated by the second organic photoelectric conversion device (OPD#N) may be the red signal.

FIG. 5C shows some example embodiments of signals generated by an image sensor that includes an organic photoelectric conversion layer 170 configured to absorb blue and green light. As shown in the upper chart of FIG. 5C, when the image sensor detects blue light in the first organic photoelectric conversion device (OPD#1) and detects both green light and blue light in the second organic photoelectric conversion device (OPD#N), the signal generated by the first organic photoelectric conversion device (OPD#1) may be subtracted from the signal generated by the second organic photoelectric conversion device (OPD#N) to obtain a green signal, while the signal generated by the first organic photoelectric conversion device (OPD#1) may be the blue signal. As shown in the lower chart of FIG. 5C, when the image sensor detects green light in the second organic photoelectric conversion device (OPD#N) and detects both green light and blues light in the first organic photoelectric conversion device (OPD#1), the signal generated by the second organic photoelectric conversion device (OPD#N) may be subtracted from the signal generated by the first organic photoelectric conversion device (OPD#1) to obtain blue signal, while the signal generated by the second organic photoelectric conversion device (OPD#N) may be the green signal.

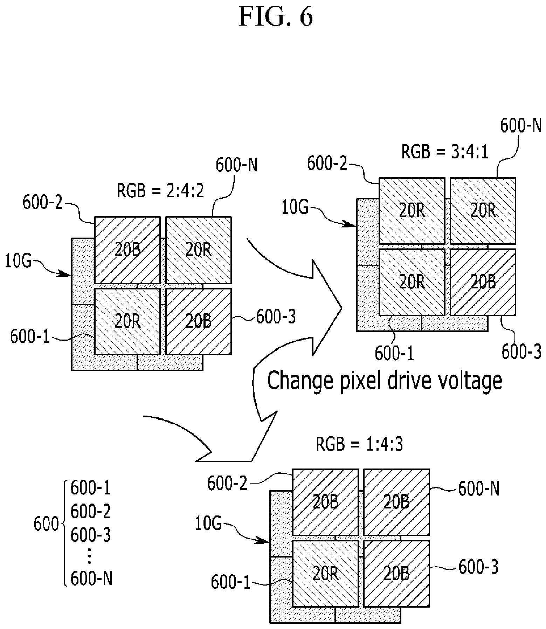

FIG. 6 is a view showing that a color ratio of a pixel may be adjusted according to an applied voltage according to the present invention.

As shown in FIG. 6, an image sensor may include a pixel array 600 of pixels 600-1 to 600-N ("N" being a positive integer), where each separate pixel 600-1 to 600-N includes a separate organic photoelectric conversion device OPD#1 to OPD#N. In some example embodiments, and as shown in FIG. 6, the separate organic photoelectric conversion devices OPD#1 to OPD#N of the separate pixels 600-1 to 600-N of an image sensor 1 are configured and/or re-configured to detect different wavelength spectra (different colors) of incident light 199 based on different voltages being applied to the separate organic photoelectric conversion devices OPD#1 to OPD#N, such that a color ratio (e.g., a ratio of the pixels configured to detect different wavelength spectra of light) of the image sensor 1 may be changed and/or controlled. As shown in a left side of FIG. 6, in a first (e.g., normal) operation mode, a ratio of a second pixel 20B of an image sensor detecting a second light (e.g., blue light) when applying a first voltage V1 to the organic photoelectric conversion device of the second pixel 20B is same as a ratio of a third pixel 20R detecting a third light (red light) by applying a second voltage V2 to the organic photoelectric conversion device of the third pixel 20R. Restated, and as shown in the left side of FIG. 6, a first voltage V1 is applied to the organic photoelectric conversion devices of pixels 600-2 and 600-4 while a second voltage V2 is applied to the organic photoelectric conversion devices of pixels 600-1 and 600-3, such that pixels 600-2 and 600-4 are configured to detect blue light based on the applied first voltage V1 and pixels 600-1 and 600-3 are configured to detect red light based on the applied second voltage V2, and such that the ratio of the combined sensor areas of pixels configured to detect blue light (second pixels 20B) to the combined sensor areas of pixels configured to detect red light (third pixels 20R) is 1/1.

In the example embodiments of the image sensor shown in the upper-right side of FIG. 6, when the operating voltage of a pixel is partially changed (e.g., the voltage applied to one or more organic photoelectric conversion devices OPD#1 to OPD#N of one or more pixels 600-1 to 600-N is changed), the ratio of the combined sensor areas of pixels configured to detect blue light (second pixels 20B) to the combined sensor areas of pixels configured to detect red light (third pixels 20R) may be reduced to be less than 1/1. In the example embodiments of the image sensor shown in the lower-right side of FIG. 6, when the operating voltage of a pixel is partially changed (e.g., the voltage applied to one or more organic photoelectric conversion devices OPD#1 to OPD#N of one or more pixels 600-1 to 600-N is changed), the ratio of the combined sensor areas of pixels configured to detect blue light (second pixels 20B) to the combined sensor areas of pixels configured to detect red light (third pixels 20R) is increased to be greater than 1/1. Accordingly, the sensitivity of different organic photoelectric conversion devices OPD#1 to OPD#N of the image sensor to different wavelength spectra of incident light 199 is separately and independently controlled.

In some example embodiments, a ratio of second pixels 20B to third pixels 20R in the image sensor 1 may refer to a ratio of a first set of one or more pixel electrodes 160-1 to 160-N to which a first voltage V1 is applied (based on the first voltage V1 being applied to the one or more organic photoelectric conversion devices OPD#1 to OPD#N that include said first set of one or more pixel electrodes 160-1 to 160-N) to a separate, second set of one or more pixel electrodes 160-1 to 160-N to which a separate, second voltage V2 is applied (based on the second voltage V2 being applied to the one or more organic photoelectric conversion devices OPD#1 to OPD#N that include said second set of one or more pixel electrodes 160-1 to 160-N). Such a ratio may be 1/1 when the image sensor 1 is operating in a normal operation mode, as shown in the left-side of FIG. 6, such that the combined sensor areas of the ratio of the combined sensor areas of pixels configured to detect blue light (second pixels 20B) to the combined sensor areas of pixels configured to detect red light (third pixels 20R) is 1/1, and such a ratio may be different from 1/1 when the image sensor 1 is operating in a mode other than the normal operation mode, as shown in the upper-right and lower-right sides of FIG. 6, such that the combined sensor areas of the ratio of the combined sensor areas of pixels configured to detect blue light (second pixels 20B) to the combined sensor areas of pixels configured to detect red light (third pixels 20R) is different from 1/1.

Although an organic and inorganic stacked structure is described in some example embodiments shown in FIGS. 1 to 6, all photoelectric conversion devices may be formed with an organic layer by changing the structure so that the first light is absorbed by another lower organic photoelectric conversion layer (not shown), besides the second light and the third light absorbed by the organic photoelectric conversion device.

Although, an image sensor which does not need a color filter by including an organic photoelectric conversion layer is described in some example embodiments shown in FIGS. 1 to 6, when more precise color separation is required, a color filter for the remaining light not detected by the organic photoelectric conversion layer may be provided on the inorganic photoelectric conversion element 110 to complete the image sensor.

Hereinafter, the present disclosure is illustrated in more detail with reference to experimental examples.

### Experimental Example 1

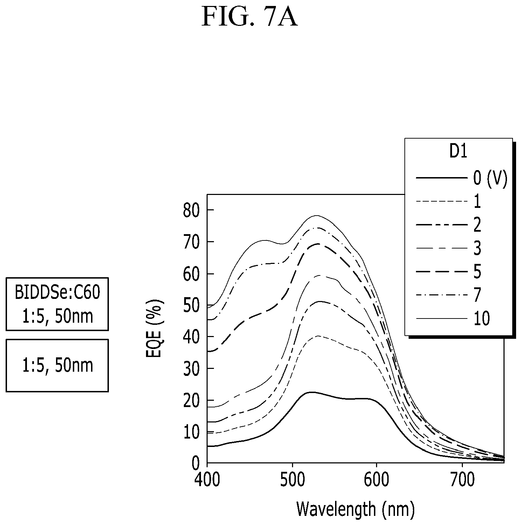

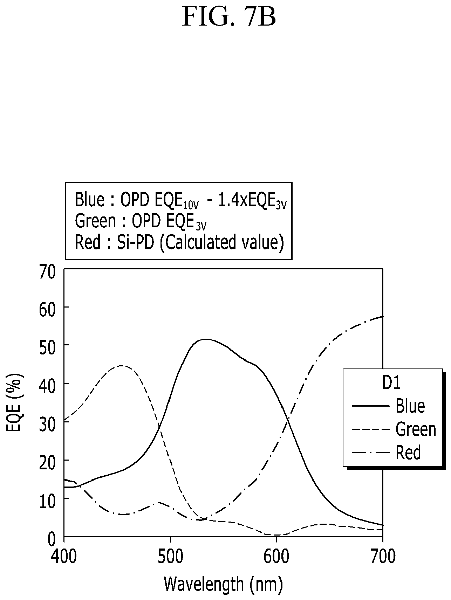

FIGS. 7A and 7B are graphs showing the results measured by an external quantum efficiency (EQE) of an organic photoelectric conversion layer formed by blending BIDD Se:C₆₀ according to an applied voltage and the results of simulating an external quantum efficiency for each wavelength using the same according to some example embodiments.

BIDD Se:C₆₀ are blended at 5:1 to provide a lower layer having a thickness of 50 nm, and BIDD Se:C₆₀ are blended at 1:5 to provide a upper layer having a thickness of 50 nm, so an organic photoelectric conversion layer is formed with the same. Subsequently, an external quantum efficiency (EQE(%)) is measured with chaining an applied voltage to 0V, 1V, 2V, 3V, 5V, 7V, 10V. The results are shown in FIG. 7A. From the results of FIG. 7A, it is confirmed that green light is detected at a low voltage, and green light and blue light are detected at a high voltage.

The results of detecting green light is obtained from the external quantum efficiency from a voltage of 3V, the results of detecting blue light is obtained from subtracting 1.4 times of the external quantum efficiency at a voltage of 3V from the external quantum efficiency at voltage of 10V, and the result of simulating the red light detection result, which is filtered and not detected in the organic photoelectric conversion layer and is detected in the inorganic silicon photodiode, is shown together in FIG. 7B. Thereby, it is confirmed that an image sensor may be accomplished without a color filter by employing the organic photoelectric conversion layer.

### Experimental Example 2

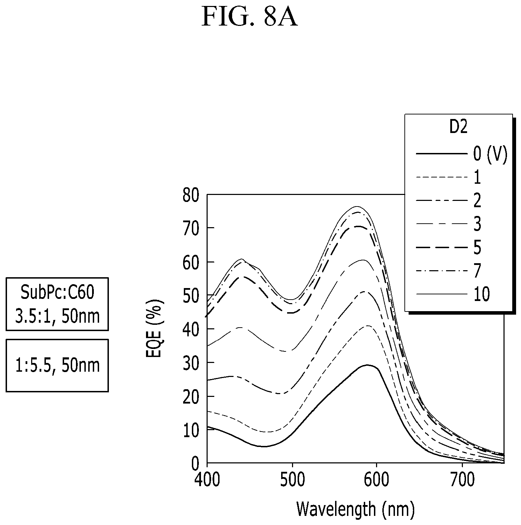

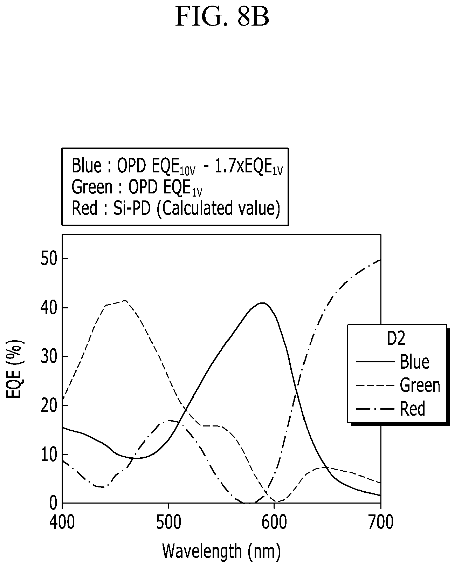

FIGS. 8A and 8B are graphs showing the results measured by an external quantum efficiency (EQE) of an organic photoelectric conversion layer formed by blending SubPc-C₆₀ according to an applied voltage and the results of simulating an external quantum efficiency for each wavelength using the same according to some example embodiments.

SubPc-C₆₀ are blended at 1:5.5 to provide a lower layer having a thickness of 50 nm, and SubPc-C₆₀ are blended at 3.5: 1 to provide a upper layer having a thickness of 50 nm, so an organic photoelectric conversion layer comprising the same is formed. Subsequently, an external quantum efficiency (EQE(%)) is measured by changing an applied voltage of 0V, 1V, 2V, 3V, 5V, 7V, 10V. The results are shown in FIG. 8A. From the results of FIG. 8A, it is confirmed that green light is detected at a low voltage, and green light and blue light are detected at a high voltage.

The results of detecting green light is obtained from the external quantum efficiency from a voltage of 1V, and the results of detecting blue light is obtained from subtracting 1.7 times of the external quantum efficiency at a voltage of 1V from the external quantum efficiency at voltage of 10V, and the result of simulating the red light detection result, which is filtered and not detected in the organic photoelectric conversion layer and is detected in the inorganic silicon photodiode, is shown together in FIG. 8B. Thereby, it is confirmed that an image sensor may be accomplished without a color filter by employing the organic photoelectric conversion layer.

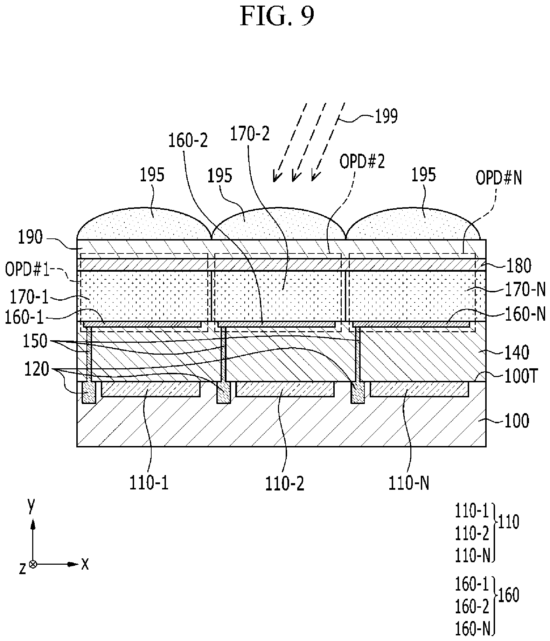

FIG. 9 is a cross-sectional view cut along with a II-II' line of FIG. 1 according to some example embodiments. Reference labels of elements in FIG. 9 that are common with reference labels of elements in FIG. 2 will be understood to refer to similar elements as the corresponding elements shown in FIG. 2, and a detailed description thereof with respect to FIG. 9 will not be provided here.

In some example embodiments, including the example embodiments shown in FIG. 9, an organic image sensor 1 may include a plurality of organic photoelectric conversion devices OPD#1 to OPD#N (N being a positive integer), where each organic photoelectric conversion device of the plurality of organic photoelectric conversion devices OPD#1 to OPD#N includes a separate organic photoelectric conversion layer 170-1 to 170-N. As shown in FIG. 9, the separate organic photoelectric conversion layers 170-1 to 170-N may be coplanar or substantially coplanar with each other, such that each separate organic photoelectric conversion layer 170-1 to 170-N is at about a same distance from the semiconductor substrate 100. Each separate organic photoelectric conversion layer 170-1 to 170-N may include one or more layers, similarly to the lower layer 170A and upper layer 170B shown in FIG. 2, but example embodiments are not limited thereto. Different organic photoelectric conversion layers 170-1 to 170-N may include different quantities of stacked layers, a single layer, or the like. Each layer of the one or more layers of each separate organic photoelectric conversion layer 170-1 to 170-N may include a particular mixture of a first material (material A) and a second material (material B). Different organic photoelectric conversion layers 170-1 to 170-N may include different layers that include different mixtures of the first and second material.

One or more of the organic photoelectric conversion layers 170-1 to 170-N may include one or more materials that are not included in one or more other organic photoelectric conversion layers 170-1 to 170-N. Referring back to FIGS. 3-4, the organic image sensor 1 is configured to independently apply separate, respective voltages to separate organic photoelectric conversion devices OPD#1 to OPD#N to separately and independently configure the separate organic photoelectric conversion devices to generate separate, respective signals based on absorbing separate, respective wavelength spectra of incident light 199.

Such separate, respective wavelength spectra of incident light are different wavelength spectra of incident light, such that separate organic photoelectric conversion devices OPD#1 to OPD#N are controlled via independent application of separate voltages to separate organic photoelectric conversion devices to detect different wavelength spectra of incident light 199.

As shown in FIG. 9, the organic image sensor 1 includes a common electrode 180 on one side of each separate organic photoelectric conversion layer 170-1 to 170-N of the plurality of the organic photoelectric conversion devices OPD#1 to OPD#N and separate, respective pixel electrodes 160-1 to 160-N of a plurality of pixel electrodes 160 on an opposite side of each separate organic photoelectric conversion layer 170-1 to 170-N of the plurality of the organic photoelectric conversion devices OPD#1 to OPD#N.

As further shown in FIG. 9, in some embodiments not forming part of the present invention, the organic image sensor 1 may include at least one inorganic photoelectric conversion device 110 within a semiconductor substrate 100, wherein the plurality of organic photoelectric conversion devices OPD#1 to OPD#N are on the semiconductor substrate 100. The at least one inorganic photoelectric conversion device 110 may be configured to absorb a third light which is not absorbed by at least one organic photoelectric conversion device of the plurality of photoelectric conversion devices OPD#1 to OPD#N. In some example embodiments, the inorganic photoelectric conversion device 110 includes a plurality of separate inorganic photoelectric conversion devices that are each aligned, in a direction extending normal to the upper surface 100T of the semiconductor substrate 100, with a separate organic photoelectric conversion device OPD#1 to OPD#N, and each given inorganic photoelectric conversion device 110 of said plurality is configured to absorb ("detect") a particular wavelength spectrum of light that is not absorbed by the respective organic photoelectric conversion device with which the given inorganic photoelectric conversion device 110 is aligned in said direction extending normal to the upper surface 100T of the semiconductor substrate 100.

While this disclosure has been described in connection with what is presently considered to be practical example embodiments, it is to be understood that the inventive concepts are not limited to the disclosed example embodiments, but, on the contrary, is intended to cover various modifications included within the scope of the appended claims.

### <Description of symbols>

110 : semiconductor substrate
110 : inorganic photoelectric conversion device
120 : charge storage section
140 : interlayer insulating layer
150 : contact
160 : pixel electrode
170 : organic photoelectric conversion layer
170A : organic photoelectric conversion layer lower layer
170B : organic photoelectric conversion layer upper layer
180 : common electrode
190 : planarization layer
195 : microlens

## Claims

1. An organic image sensor (1), comprising:
an organic photoelectric conversion layer (170) including a first material and a second material, the first material configured to absorb a first wavelength spectrum of light, the second material configured to absorb a second wavelength spectrum of light, and
a common electrode (180) on one side of the organic photoelectric conversion layer and a plurality of pixel electrodes (160) on an opposite side of the organic photoelectric conversion layer,
wherein the organic photoelectric conversion layer includes a lower layer (170A) and an upper layer (170B) stacked upon the lower layer, a material composition of the lower layer being a first mixture of the first and second materials, a material composition of the upper layer being a second mixture of the first and second materials,
wherein the plurality of pixel electrodes define separate, first (OPD#1) and second (OPD#N) organic photoelectric conversion devices in the organic image sensor, such that
the first organic photoelectric conversion device includes a first pixel electrode of the plurality of pixel electrodes, a first portion of the organic photoelectric conversion layer and a first portion of the common electrode, and
the second organic photoelectric conversion device includes a separate, second pixel electrode of the plurality of pixel electrodes, a separate, second portion of the organic photoelectric conversion layer and a separate, second portion of the common electrode,
wherein a ratio of the first material to the second material in the first mixture is greater than 1/1, and a ratio of the first material to the second material in the second mixture is less than 1/1, **characterized in that** the organic image sensor is configured to apply a first voltage (V1) in the first organic photoelectric conversion device and configured to concurrently apply a second voltage (V2) in the second organic photoelectric conversion device, a magnitude of the second voltage being greater than a magnitude of the first voltage.

2. The organic image sensor of claim 1, wherein the ratio of the first material to the second material in the first mixture is greater than 3/1, and the ratio of the first material to the second material in the second mixture is less than 1/3.

3. The organic image sensor of claim 1, wherein the first organic photoelectric conversion device (OPD#1) is configured to generate a signal associated with one of the first and second wavelength spectra of light in response to the organic image sensor applying the first bias voltage (V1) to the first organic photoelectric conversion device and the organic image sensor being irradiated with incident light that includes the first and second wavelength spectra of light, and
the second organic photoelectric conversion device (OPD#N) is configured to generate a signal associated with the other of the first and second wavelength spectra of light in response to the organic image sensor applying the second bias voltage (V2) to the second organic photoelectric conversion device and the organic image sensor being irradiated with the incident light.

4. The organic image sensor of claim 1, wherein the first voltage (V1) is applied between the common electrode and a first pixel electrode in the first organic photoelectric conversion device and the second voltage (V2) is applied between the common electrode and a second pixel electrode in the second organic photoelectric conversion device.

5. An organic/inorganic stacked image sensor (1), comprising:
a plurality of inorganic photoelectric conversion devices (110) within a semiconductor substrate (100);
an organic photoelectric conversion layer (170) on the semiconductor substrate;
first (OPD#1) and second (OPD#N) organic photoelectric conversion devices, the first organic photoelectric conversion device including a first portion of the organic photoelectric conversion layer (170) and configured to absorb a first wavelength spectrum of light, and the second organic photoelectric conversion device including a separate, second portion of the organic photoelectric conversion layer and configured to absorb a separate, second wavelength spectrum of light;
wherein each inorganic photoelectric conversion device (110) of the plurality of inorganic photoelectric conversion devices is configured to absorb a third wavelength spectrum of light which is not absorbed by the first organic photoelectric conversion device or the second organic photoelectric conversion device;
wherein the organic/inorganic stacked image sensor does not include any color filter device;
wherein the organic photoelectric conversion layer (170) includes a first material and a second material, the first material configured to absorb the first wavelength spectrum of light, and the second material configured to absorb the second wavelength spectrum of light;
and wherein the organic photoelectric conversion layer (170) includes a lower layer (170A) and an upper layer (170B) stacked upon the lower layer, the material composition of the lower layer being a first mixture of the first and second materials, and the material composition of the upper layer being a second mixture of the first and second materials, the ratio of the first material to the second material in the first mixture being greater than 1/1, and the ratio of the first material to the second material in the second mixture being less than 1/1;
a common electrode (180) on one side of the organic photoelectric conversion layer (170) and a plurality of pixel electrodes (160) on an opposite side of the organic photoelectric conversion layer;
wherein the plurality of pixel electrodes define the separate first and second organic photoelectric conversion devices (OPD#1, OPD#N) in the organic/inorganic stacked image sensor, such that:
the first organic photoelectric conversion device (OPD#1) further includes a first pixel electrode of the plurality of pixel electrodes and a first portion of the common electrode, and
the second organic photoelectric conversion device (OPD#N) further includes a separate, second pixel electrode of the plurality of pixel electrodes and a separate, second portion of the common electrode;
**characterized in that**
the organic/inorganic stacked image sensor is configured to apply a first bias voltage (V1) to the first organic photoelectric conversion device (OPD#1) and configured to concurrently apply a second bias voltage (V2) to the second organic photoelectric conversion device (OPD#N), the magnitude of the second voltage being greater than the magnitude of the first voltage.

6. The organic/inorganic stacked image sensor of claim 5, further comprising:
an interlayer insulation layer (140) between an upper surface of the semiconductor substrate (110) and an exposed lower surface of the organic photoelectric conversion layer (170); and
a contact (150) configured to couple the first organic photoelectric conversion device and the second organic photoelectric conversion device with a charge storage section on the semiconductor substrate.

7. The organic/inorganic stacked image sensor of claim 5 or 6, further comprising:
a planarization layer (190) and a microlens array layer (195) on the common electrode (180).

8. The organic/inorganic stacked image sensor of claim 5, wherein the first bias voltage (V1) is applied between the common electrode and the first pixel electrode in the first organic photoelectric conversion device (OPD#1), and the second bias voltage (V2) is applied between the common electrode and the second pixel electrode in the second organic photoelectric conversion device (OPD#N).

## Patentansprüche

1. Organischer Bildsensor (1), umfassend:
eine organische photoelektrische Umwandlungsschicht (170), die ein erstes Material und ein zweites Material einschließt, wobei das erste Material dazu konfiguriert ist, ein erstes Wellenlängenspektrum von Licht zu absorbieren, wobei das zweite Material dazu konfiguriert ist, ein zweites Wellenlängenspektrum von Licht zu absorbieren, und
eine gemeinsame Elektrode (180) auf einer Seite der organischen photoelektrischen Umwandlungsschicht und eine Vielzahl von Pixelelektroden (160) auf einer gegenüberliegenden Seite der organischen photoelektrischen Umwandlungsschicht,
wobei die organische photoelektrische Umwandlungsschicht eine untere Schicht (170A) und eine obere Schicht (170B) einschließt, die auf die untere Schicht gestapelt ist, wobei eine Materialzusammensetzung der unteren Schicht eine erste Mischung aus dem ersten und dem zweiten Material ist, wobei eine Materialzusammensetzung der oberen Schicht eine zweite Mischung aus dem ersten und dem zweiten Material ist,
wobei die Vielzahl von Pixelelektroden eine erste (OPD#1) und eine zweite (OPD#N) organische photoelektrische Umwandlungsvorrichtung, die separat sind, in dem organischen Bildsensor definieren, sodass
die erste organische photoelektrische Umwandlungsvorrichtung eine erste Pixelelektrode der Vielzahl von Pixelelektroden, einen ersten Abschnitt der organischen photoelektrischen Umwandlungsschicht und einen ersten Abschnitt der gemeinsamen Elektrode einschließt, und
die zweite organische photoelektrische Umwandlungsvorrichtung eine separate zweite Pixelelektrode der Vielzahl von Pixelelektroden, einen separaten zweiten Abschnitt der organischen photoelektrischen Umwandlungsschicht und einen separaten zweiten Abschnitt der gemeinsamen Elektrode einschließt,
wobei ein Verhältnis des ersten Materials zum zweiten Material in der ersten Mischung größer als 1/1 ist und ein Verhältnis des ersten Materials zum zweiten Material in der zweiten Mischung kleiner als 1/1 ist, **dadurch gekennzeichnet, dass**
der organische Bildsensor dazu konfiguriert ist, eine erste Spannung (V1) in der ersten organischen photoelektrischen Umwandlungsvorrichtung anzulegen, und dazu konfiguriert ist, gleichzeitig eine zweite Spannung (V2) in der zweiten organischen photoelektrischen Umwandlungsvorrichtung anzulegen, wobei der Betrag der zweiten Spannung größer als der Betrag der ersten Spannung ist.

2. Organischer Bildsensor nach Anspruch 1, wobei das Verhältnis des ersten Materials zum zweiten Material in der ersten Mischung größer als 3/1 ist und das Verhältnis des ersten Materials zum zweiten Material in der zweiten Mischung kleiner als 1/3 ist.

3. Organischer Bildsensor nach Anspruch 1, wobei die erste organische photoelektrische Umwandlungsvorrichtung (OPD#1) dazu konfiguriert ist, als Reaktion darauf, dass der organische Bildsensor die erste Vorspannung (V1) an die erste organische photoelektrische Umwandlungsvorrichtung anlegt und der organische Bildsensor mit einfallendem Licht bestrahlt, welches das erste und das zweite Wellenlängenspektrum von Licht einschließt, ein Signal zu erzeugen, das mit einem von dem ersten und dem zweiten Wellenlängenspektrum von Licht assoziiert ist, und
die zweite organische photoelektrische Umwandlungsvorrichtung (OPD#N) dazu konfiguriert ist, als Reaktion darauf, dass der organische Bildsensor die zweite Vorspannung (V2) an die zweite organische photoelektrische Umwandlungsvorrichtung anlegt und der organische Bildsensor mit dem einfallenden Licht bestrahlt wird, ein Signal zu erzeugen, das mit dem anderen von dem ersten und dem zweiten Wellenlängenspektrum von Licht assoziiert ist.

4. Organischer Bildsensor nach Anspruch 1, wobei die erste Spannung (V1) zwischen der gemeinsamen Elektrode und einer ersten Pixelelektrode in der ersten organischen photoelektrischen Umwandlungsvorrichtung angelegt wird und die zweite Spannung (V2) zwischen der gemeinsamen Elektrode und einer zweiten Pixelelektrode in der zweiten organischen photoelektrischen Umwandlungsvorrichtung angelegt wird.

5. Organischer/anorganischer gestapelter Bildsensor (1), umfassend:
mehrere anorganische photoelektrische Umwandlungsvorrichtungen (110) innerhalb eines Halbleitersubstrats (100);
eine organische photoelektrische Umwandlungsschicht (170) auf dem Halbleitersubstrat;
eine erste (OPD#1) und eine zweite (OPD#N) organische photoelektrische Umwandlungsvorrichtung, wobei die erste organische photoelektrische Umwandlungsvorrichtung einen ersten Abschnitt der organischen photoelektrischen Umwandlungsschicht (170) einschließt und dazu konfiguriert ist, ein erstes Wellenlängenspektrum von Licht zu absorbieren, und die eine zweite organische photoelektrische Umwandlungsvorrichtung einen separaten zweiten Abschnitt der organischen photoelektrischen Umwandlungsschicht einschließt und dazu konfiguriert ist, ein separates zweites Wellenlängenspektrum von Licht zu absorbieren;
wobei jede anorganische photoelektrische Umwandlungsvorrichtung (110) der Vielzahl von anorganischen photoelektrischen Umwandlungsvorrichtungen dazu konfiguriert ist, ein drittes Wellenlängenspektrum von Licht zu absorbieren, das nicht von der ersten organischen photoelektrischen Umwandlungsvorrichtung oder der zweiten organischen photoelektrischen Umwandlungsvorrichtung absorbiert wird;
wobei der organische/anorganische gestapelte Bildsensor keine Farbfiltervorrichtung einschließt;
wobei die organische photoelektrische Umwandlungsschicht (170) ein erstes Material und ein zweites Material einschließt, wobei das erste Material dazu konfiguriert ist, das erste Wellenlängenspektrum von Licht zu absorbieren, und das zweite Material dazu konfiguriert ist, das zweite Wellenlängenspektrum von Licht zu absorbieren;
und wobei die organische photoelektrische Umwandlungsschicht (170) eine untere Schicht (170A) und eine obere Schicht (170B) einschließt, die auf die untere Schicht gestapelt ist, wobei die Materialzusammensetzung der unteren Schicht eine erste Mischung aus dem ersten und dem zweiten Material ist und die Materialzusammensetzung der oberen Schicht eine zweite Mischung aus dem ersten und dem zweiten Material ist, wobei das Verhältnis des ersten Materials zum zweiten Material in der ersten Mischung größer als 1/1 ist und das Verhältnis des ersten Materials zum zweiten Material in der zweiten Mischung kleiner als 1/1 ist;
eine gemeinsame Elektrode (180) auf einer Seite der organischen photoelektrischen Umwandlungsschicht (170) und eine Vielzahl von Pixelelektroden (160) auf einer gegenüberliegenden Seite der organischen photoelektrischen Umwandlungsschicht;
wobei die Vielzahl von Pixelelektroden die erste und die zweite organische photoelektrische Umwandlungsvorrichtung (OPD#1, OPD#N), die separat sind, in dem organischen/anorganischen gestapelten Bildsensor definieren, sodass:
die erste organische photoelektrische Umwandlungsvorrichtung (OPD#1) ferner eine erste Pixelelektrode der Vielzahl von Pixelelektroden und einen ersten Abschnitt der gemeinsamen Elektrode einschließt, und
die zweite organische photoelektrische Umwandlungsvorrichtung (OPD#N) ferner eine separate zweite Pixelelektrode der Vielzahl von Pixelelektroden und einen separaten zweiten Abschnitt der gemeinsamen Elektrode einschließt;
**dadurch gekennzeichnet, dass**
der organische/anorganische gestapelte Bildsensor dazu konfiguriert ist, eine erste Vorspannung (V1) an die erste organische photoelektrische Umwandlungsvorrichtung (OPD#1) anzulegen, und dazu konfiguriert ist, gleichzeitig eine zweite Vorspannung (V2) an die zweite organische photoelektrische Umwandlungsvorrichtung (OPD#N) anzulegen, wobei der Betrag der zweiten Spannung größer als der Betrag der ersten Spannung ist.

6. Organischer/anorganischer gestapelter Bildsensor nach Anspruch 5, ferner umfassend:
eine Zwischenschicht-Isolierschicht (140) zwischen einer oberen Oberfläche des Halbleitersubstrats (110) und einer freigelegten unteren Oberfläche der organischen photoelektrischen Umwandlungsschicht (170); und
einen Kontakt (150), der dazu konfiguriert ist, die erste organische photoelektrische Umwandlungsvorrichtung und die zweite organische photoelektrische Umwandlungsvorrichtung mit einem Ladungsspeicherbereich auf dem Halbleitersubstrat zu koppeln.

7. Organischer/anorganischer gestapelter Bildsensor nach Anspruch 5 oder 6, ferner umfassend: eine Planarisierungsschicht (190) und eine Mikrolinsen-Array-Schicht (195) auf der gemeinsamen Elektrode (180).

8. Organischer/anorganischer gestapelter Bildsensor nach Anspruch 5, wobei die erste Vorspannung (V1) zwischen der gemeinsamen Elektrode und der ersten Pixelelektrode in der ersten organischen photoelektrischen Umwandlungsvorrichtung (OPD#1) angelegt wird und die zweite Vorspannung (V2) zwischen der gemeinsamen Elektrode und der zweiten Pixelelektrode in der zweiten organischen photoelektrischen Umwandlungsvorrichtung (OPD#N) angelegt wird.

## Revendications

1. Capteur d'image organique (1), comprenant :
une couche de conversion photoélectrique organique (170) comprenant un premier matériau et un second matériau, le premier matériau étant conçu pour absorber un premier spectre de longueur d'onde de lumière, le second matériau étant conçu pour absorber un deuxième spectre de longueur d'onde de lumière, et
une électrode commune (180) sur un côté de la couche de conversion photoélectrique organique et une pluralité d'électrodes de pixel (160) sur un côté opposé de la couche de conversion photoélectrique organique,
ladite couche de conversion photoélectrique organique comprenant une couche inférieure (170A) et une couche supérieure (170B) empilée sur la couche inférieure, une composition matérielle de la couche inférieure étant un premier mélange des premier et second matériaux, une composition matérielle de la couche supérieure étant un second mélange des premier et second matériaux,
ladite pluralité d'électrodes de pixel définissant des premier (OPD#1) et second (OPD#N) dispositifs de conversion photoélectrique organiques séparés dans le capteur d'image organique, de sorte que
le premier dispositif de conversion photoélectrique organique comprenne une première électrode de pixel de la pluralité d'électrodes de pixel, une première partie de la couche de conversion photoélectrique organique et une première partie de l'électrode commune, et
le second dispositif de conversion photoélectrique organique comprenne une seconde électrode de pixel séparée de la pluralité d'électrodes de pixel, une seconde partie séparée de la couche de conversion photoélectrique organique et une seconde partie séparée de l'électrode commune,
un rapport du premier matériau sur le second matériau dans le premier mélange étant supérieur à 1/1, et un rapport du premier matériau sur le second matériau dans le second mélange étant inférieur à 1/1, **caractérisé en ce que**
le capteur d'image organique est conçu pour appliquer une première tension (V1) dans le premier dispositif de conversion photoélectrique organique et conçu pour appliquer simultanément une seconde tension (V2) dans le second dispositif de conversion photoélectrique organique, l'amplitude de la seconde tension étant supérieure à une amplitude de la première tension.

2. Capteur d'image organique selon la revendication 1, ledit rapport du premier matériau sur le second matériau dans le premier mélange étant supérieur à 3/1, et ledit rapport du premier matériau sur le second matériau dans le second mélange étant inférieur à 1/3.

3. Capteur d'image organique selon la revendication 1, ledit premier dispositif de conversion photoélectrique organique (OPD#1) étant conçu pour générer un signal associé à l'un des premier et deuxième spectres de longueur d'onde de la lumière en réponse au capteur d'image organique appliquant la première tension de polarisation (V1) au premier dispositif de conversion photoélectrique organique et le capteur d'image organique étant irradiés avec une lumière incidente qui comprend les premier et deuxième spectres de longueur d'onde de lumière, et
ledit second dispositif de conversion photoélectrique organique (OPD#N) étant conçu pour générer un signal associé à l'autre des premier et deuxième spectres de longueur d'onde de la lumière en réponse au capteur d'image organique appliquant la seconde tension de polarisation (V2) au second dispositif de conversion photoélectrique organique et le capteur d'image organique étant irradié avec la lumière incidente.

4. Capteur d'image organique selon la revendication 1, ladite première tension (V1) étant appliquée entre l'électrode commune et une première électrode de pixel dans le premier dispositif de conversion photoélectrique organique et ladite seconde tension (V2) étant appliquée entre l'électrode commune et une seconde électrode de pixel dans le second dispositif de conversion photoélectrique organique.

5. Capteur d'image empilé organique/inorganique (1), comprenant :
une pluralité de dispositifs de conversion photoélectrique inorganiques (110) à l'intérieur d'un substrat semi-conducteur (100) ;
une couche de conversion photoélectrique organique (170) sur le substrat semi-conducteur ;
des premier (OPD#1) et second (OPD#N) dispositifs de conversion photoélectrique organiques, le premier dispositif de conversion photoélectrique organique comprenant une première partie de la couche de conversion photoélectrique organique (170) et conçu pour absorber un premier spectre de longueur d'onde de lumière, et le second dispositif de conversion photoélectrique organique comprenant une seconde partie séparée de la couche de conversion photoélectrique organique et conçu pour absorber un deuxième spectre de longueur d'onde de lumière séparé ;
chaque dispositif de conversion photoélectrique inorganique (110) de la pluralité de dispositifs de conversion photoélectrique inorganiques étant conçu pour absorber un troisième spectre de longueur d'onde de lumière qui n'est pas absorbé par le premier dispositif de conversion photoélectrique organique ou le second dispositif de conversion photoélectrique organique ;
ledit capteur d'image empilé organique/inorganique ne comprenant aucun dispositif de filtre de couleur ;
ladite couche de conversion photoélectrique organique (170) comprenant un premier matériau et un second matériau, le premier matériau étant conçu pour absorber le premier spectre de longueur d'onde de lumière, et le second matériau étant conçu pour absorber le deuxième spectre de longueur d'onde de lumière ;
et ladite couche de conversion photoélectrique organique (170) comprenant une couche inférieure (170A) et une couche supérieure (170B) empilée sur la couche inférieure, la composition matérielle de la couche inférieure étant un premier mélange des premier et second matériaux, et le la composition matérielle de la couche supérieure étant un second mélange des premier et second matériaux, le rapport du premier matériau sur le second matériau dans le premier mélange étant supérieur à 1/1, et le rapport du premier matériau sur le second matériau dans le second mélange étant inférieur à 1/1 ;
une électrode commune (180) sur un côté de la couche de conversion photoélectrique organique (170) et une pluralité d'électrodes de pixel (160) sur un côté opposé de la couche de conversion photoélectrique organique ;
ladite pluralité d'électrodes de pixel définissant les premier et second dispositifs de conversion photoélectrique organiques séparés (OPD#1, OPD#N) dans le capteur d'image empilé organique/inorganique, de sorte que :
le premier dispositif de conversion photoélectrique organique (OPD#1) comprenne en outre une première électrode de pixel de la pluralité d'électrodes de pixel et une première partie de l'électrode commune, et
le second dispositif de conversion photoélectrique organique (OPD#N) comprenne en outre une seconde électrode de pixel séparée de la pluralité d'électrodes de pixel et une seconde partie séparée de l'électrode commune ;
**caractérisé en ce que**
le capteur d'image empilé organique/inorganique est conçu pour appliquer une première tension de polarisation (V1) au premier dispositif de conversion photoélectrique organique (OPD#1) et conçu pour appliquer simultanément une seconde tension de polarisation (V2) au second dispositif de conversion photoélectrique organique (OPD#N), l'amplitude de la seconde tension étant supérieure à l'amplitude de la première tension.

6. Capteur d'image empilé organique/inorganique selon la revendication 5, comprenant en outre :
une couche d'isolation intercouche (140) entre une surface supérieure du substrat semi-conducteur (110) et une surface inférieure exposée de la couche de conversion photoélectrique organique (170) ; et
un contact (150) conçu pour coupler le premier dispositif de conversion photoélectrique organique et le second dispositif de conversion photoélectrique organique avec une section de stockage de charge sur le substrat semi-conducteur.

7. Capteur d'image empilé organique/inorganique selon la revendication 5 ou 6, comprenant en outre :
une couche de planarisation (190) et une couche de réseau de microlentilles (195) sur l'électrode commune (180).

8. Capteur d'image empilé organique/inorganique selon la revendication 5, ladite première tension de polarisation (V1) étant appliquée entre l'électrode commune et la première électrode de pixel dans le premier dispositif de conversion photoélectrique organique (OPD#1), et ladite seconde tension de polarisation (V2) étant appliquée entre l'électrode commune et la seconde électrode de pixel dans le second dispositif de conversion photoélectrique organique (OPD#N).
